# FASCICULE DE BREVET EUROPEEN

(11) **EP 2 435 842 B1**
(45) Date de publication et mention de la délivrance du brevet: **05.06.2019**
(21) Numéro de dépôt: 10715799.2
(22) Date de dépôt: 19.04.2010
(51) Int. Cl.: G01R 19/155, G01R 31/40, G01R 19/15, G01R 19/165, G01R 31/08

(54) **PROCÉDÉ DE DÉTERMINATION DE L'ORIGINE DE PANNES DE COURANT**
VERFAHREN ZUR BESTIMMUNG DER URSACHE VON STROMAUSFÄLLEN
METHOD FOR DETERMINING THE ORIGIN OF POWER OUTAGES

(30) Priorité: 29.05.2009 FR 0953573
(43) Date de publication de la demande: 04.04.2012
(73) Titulaire: SAGEMCOM ENERGY & TELECOM SAS, 92500 Rueil-Malmaison (FR)
(72) Inventeur: BACRI, Guillaume, 75014 Paris (FR); BAROIS, Jérôme, 92400 Courbevoie (FR); POLIDORO, Marc, 60240 Delincourt (FR); DUBOIS, Julien, 75009 Paris (FR)
(74) Mandataire: Camus, Olivier Jean-Claude
(86) Numéro de dépôt international: PCT/EP2010/055130
(87) Numéro de publication internationale: WO 2010/136266

(56) Documents cités:
- WO-A-2006/091177
- GB-A- 2 132 429
- US-A- 5 940 009
- US-A1- 2004 061 616
- US-A1- 2006 217 936
- US-A1- 2008 068 004
- US-A1- 2009 135 018
- US-B1- 6 665 620

## Description

### DOMAINE TECHNIQUE DE L'INVENTION

La présente invention a pour objet un procédé de détermination de l'origine de pannes de courant. Le procédé selon l'invention a vocation à être mis en oeuvre dans un environnement domestique, ou, d'une façon un peu plus générale, dans un environnement dans lequel se trouve un compteur, par exemple un compteur électrique, un compteur d'eau ou encore un compteur à gaz, dont la fonction première est de mesurer des quantités d'électricité, d'eau ou de gaz consommées.

Le domaine de l'invention est, d'une façon générale, celui de la surveillance du fonctionnement de l'alimentation électrique d'un endroit donné. Elle a essentiellement pour but de renseigner à distance sur une origine probable d'une défaillance observée dans le fonctionnement électrique de l'endroit surveillé, ladite défaillance pouvant par exemple être une défaillance de l'alimentation électrique de l'endroit considéré, une défaillance d'un capteur relié à un compteur, une défaillance d'une alimentation d'une passerelle, ou encore une coupure volontaire de l'électricité dans l'endroit considéré.

### ARRIERE-PLAN TECHNOLOGIQUE DE L'INVENTION

Dans le domaine des compteurs, afin de collecter à distance les informations concernant une grandeur physique telle que de l'eau, le gaz, la chaleur, l'électricité etc., une unité d'acquisition de données telle qu'un capteur est reliée audit compteur et est apte à coopérer avec un dispositif de communication tel qu'un serveur distant. Le capteur comprend ainsi au moins un fil de relais d'impulsions électriques qui le relie au compteur ; ledit capteur étant apte à échanger avec une interface, par exemple par voie radio, différentes données, notamment des données relatives à la consommation attachée au compteur considéré. L'interface considéré est alors apte à transmettre les données reçues à un serveur distant, par exemple un serveur appartenant au fournisseur de la source d'énergie associée au capteur considéré.

Dans une optique générale de surveillance du fonctionnement des compteurs installés dans des endroits donnés, par exemple des compteurs installés dans des domiciles, il apparait intéressant de pouvoir bénéficier, avantageusement de manière distante, d'une surveillance du fonctionnement électrique de l'endroit donné. En effet, une telle surveillance permet notamment, en déterminant l'origine de la défaillance, de déterminer si une intervention dans l'endroit considéré est nécessaire ou non.

Les documents WO-2006/091177 A1 et US-2004/0061616 A1 divulguent des systèmes pour effectuer une notification de défaillance de courant.

Cependant, dans l'état de la technique, il n'existe aucune solution permettant de renseigner à distance sur l'origine d'une défaillance observée dans le fonctionnement électrique d'un endroit surveillé.

### DESCRIPTION GENERALE DE L'INVENTION

Le procédé selon la revendication 1 et le dispositif selon la revendication 3 apportent une réponse à cette lacune. Dans l'invention, on propose une solution pour détecter une défaillance électrique d'un endroit à surveiller, de s'intéresser à une éventuelle défaillance de l'alimentation électrique d'une passerelle, dite "energy gateway", ladite passerelle constituant un bloc communicant entre :
- un serveur extérieur à l'endroit à surveiller, par exemple disposé chez le distributeur d'énergie associée à un compteur installé dans ledit endroit à surveiller ;
- un ou plusieurs capteurs associés audit compteur, lesdits capteurs étant installés dans l'endroit à surveiller.

La passerelle est typiquement un accessoire équipé d'une radio, et rattaché à une boîte, ou box, de communication de type LiveBox (Marque déposée).

Pour atteindre cet objectif de surveillance, on propose, dans l'invention, d'effectuer une synthèse de différents événements susceptibles d'être observés. Les événements considérés se traduisent par des informations provenant par liaison radio depuis un capteur relié au compteur, et/ou par des informations internes à la passerelle, notamment une information relative à l'état de l'alimentation électrique de la passerelle.

L'invention concerne donc essentiellement un procédé de détermination de l'origine de pannes de courant dans un lieu équipé d'un compteur, comme définit dans la revendication 1 et un dispositif correspondant comme définit dans la revendication 3.

Le procédé selon l'invention peut comporter, en plus des étapes principales qui viennent d'être mentionnées dans la revendication 1, des caractéristiques suivantes:
- un signal de type signal TIC doit être échangé entre le compteur et le capteur, ledit procédé selon l'invention comportant, en cas de détection d'une défaillance de l'alimentation du bloc secteur, les différentes étapes supplémentaires consistant à
- déterminer si le signal de type signal TIC est effectivement échangé entre le compteur et le capteur ; dans la négative, interpréter l'absence de signal TIC comme révélatrice d'une défaillance du fournisseur d'électricité ; dans l'affirmative, déterminer, en décodant au moyen du microcontrôleur le signal de compteur présent sur une liaison reliant le capteur au compteur, si une consommation d'énergie du compteur est nulle ou non ; - si le signal de compteur décodé révèle une consommation d'énergie nulle, interpréter le signal de compteur comme révélateur de la présence du disjoncteur du lieu considéré dans une position bloquée ; si le signal de compteur décodé révèle une consommation d'énergie non nulle, interpréter le signal de compteur comme révélateur d'une défaillance du bloc secteur.

L'invention et ses différentes applications seront mieux comprises à la lecture de la description qui suit et à l'examen des figures qui l'accompagnent.

### BREVE DESCRIPTION DES FIGURES

Celles-ci ne sont présentées qu'à titre indicatif et nullement limitatif de l'invention. Les figures montrent :
- à la figure 1, une représentation schématique d'une installation permettant l'exécution d'un exemple de mise en oeuvre du procédé selon l'invention ;
- à la figure 2, un exemple de représentation d'un module électronique susceptible d'intervenir dans certains exemples de mise en oeuvre du procédé selon l'invention ;
- à la figure 3, un premier exemple de mise en oeuvre du procédé selon l'invention ;
- à la figure 4, un deuxième exemple, qui n'est pas couvert par les revendications.

### DESCRIPTION DES FORMES DE REALISATION PREFEREES DE L'INVENTION

Les différents éléments apparaissant sur plusieurs figures auront gardé, sauf précision contraire, la même référence.

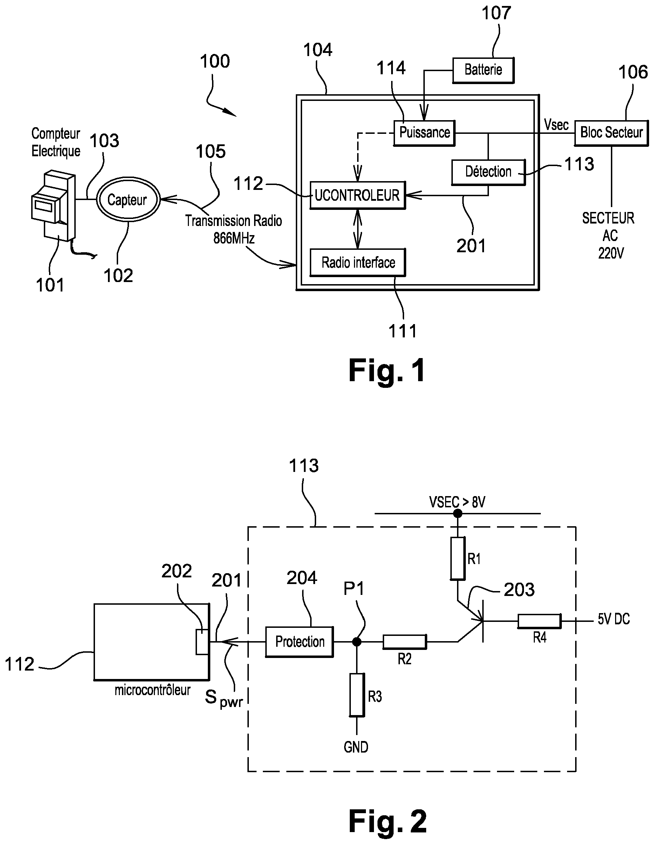

A la figure 1, on a représenté une installation 100 permettant l'exécution d'un exemple de mise en oeuvre du procédé selon l'invention.

Dans l'installation 100, on a disposé :
- un compteur 101, par exemple de type compteur électrique ;
- un capteur 102, relié au compteur 101 par une liaison filaire 103 ; avantageusement, dans certains exemples de mise en oeuvre du procédé selon l'invention, la liaison filaire 103 est une liaison de type liaison TIC , pour liaison Téléinformation Client. Cette liaison transmet des trames TIC, aussi appelées signal TIC, qui sont générées à des instants préalablement déterminées, et qui sont par exemple des trames désignées comme suit : Adresse du compteur, Mot d'état du compteur, Intensité Instantanée, Présence de potentiels, Période tarifaire en cours. Chaque trame est horodatée par le capteur.
- une passerelle 104, recevant des informations par une voie radio 105 fonctionnant par exemple à une fréquence de 868 MHz (Méga Hertz) ; la passerelle 104 est du type "Energy Gateway" mentionnée précédemment ;
- une alimentation secteur 106, fournissant une tension Vsec, ladite alimentation secteur étant reliée à la passerelle 104, afin d'assurer l'alimentation électrique de ladite passerelle 104 dans des conditions habituelles, non défaillantes, de fonctionnement du système 100;
- une batterie 107, reliée à la passerelle 104, afin d'assurer l'alimentation de ladite passerelle 104 dans des conditions dégradées de fonctionnement du système 100, lorsque l'alimentation secteur est défaillante.

La passerelle 104 comporte notamment les modules électroniques suivants :
- une interface radio 111 apte à échanger des signaux avec le capteur 102 par voie radio ;
- un bloc de détection de défaillance 113 du bloc secteur 106 ;
- un bloc de puissance 114, relié à la fois à l'alimentation secteur 106 et à la batterie 107, assurant le basculement, selon des techniques connues, de l'alimentation de la passerelle 104, ledit basculement consistant à utiliser l'alimentation de ladite batterie 107 lorsque l'alimentation secteur 106 est défaillante ;
- un microcontrôleur 112, relié à l'interface radio 111, au bloc de détection de défaillance 113 et au bloc de puissance 114 ; le microcontrôleur est apte à interpréter les signaux reçus des différents modules auxquels il est relié, et à gérer en conséquence le fonctionnement de la passerelle 104.

Sur la figure 2, on a représenté un exemple de réalisation du bloc de détection de défaillance 113 du bloc secteur 106 qui est relié au microcontrôleur 112 par une liaison 201 arrivant au niveau d'un port spécifique 202 dudit microcontrôleur.

Dans l'exemple représenté, le bloc 113 comporte un transistor bipolaire PNP, dans lequel :
- le collecteur est relié, via une première résistance R1, au bloc secteur 106 ;
- l'émetteur est relié, via un pont diviseur de tension, à un bloc de protection 204 ; le pont diviseur de tension est constitué d'une deuxième résistance R2, disposée entre l'émetteur et le bloc de protection 204, et d'une troisième résistance R3, disposée entre un point de connexion A1 situé entre la deuxième résistance R2 et le bloc de protection 204, et un point porté à un potentiel de référence GND ;
- la base au niveau de laquelle est appliquée, au travers d'une quatrième résistance R4, une tension de 5 Volts (Merci de dire qui fournit l'alimentation de 5 volts).

Dans un exemple particulier de réalisation, les valeurs des différentes résistances sont les suivantes :
R1= 22 kilo-ohms ;
R2= 22 kilo-ohms ;
R3= 100 kilo-ohms ;
R4= 330 kilo-ohms.

Le bloc de protection 204 permet de protéger le microcontrôleur 112 des pics de tension susceptibles d'être observés, et qui risqueraient d'endommager ledit microcontrôleur 112.

Ainsi, quand la tension Vsec est nettement supérieure à la tension de base du transistor 203, ici 5V, le transistor 203 est passant. On observe alors une tension positive aux bornes de la résistance R2. On obtient ainsi un signal Spwr présentant une tension logique à un niveau haut à l'entrée 202 du microprocesseur.

Quand la tension Vsec est nettement inférieure à la tension de base du transistor 203 (5V), ce qui se produit quand la tension Vsec est nulle, c'est-à-dire lorsque le bloc secteur 106 est défaillant, le transistor est bloqué et on obtient alors le signal Spwr présentant une tension logique à un niveau bas en entrée 202 du microcontrôleur 112.

L'installation qui vient d'être décrite en référence aux figures 1 et 2 permet la mise en place de différents modes de mise en oeuvre du procédé selon l'invention.

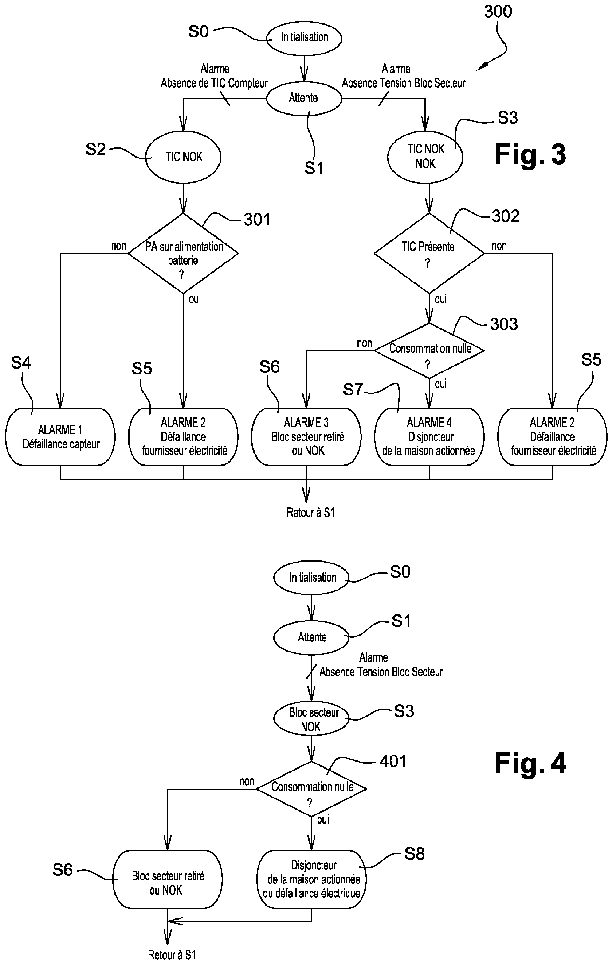

Ainsi, à la figure 3, on illustre, au moyen d'une machine d'état 300 implémentée dans le microcontrôleur 112, un premier exemple de mise en oeuvre du procédé selon l'invention. Dans cet exemple, la liaison 103 reliant le compteur 101 et le capteur 102 est une liaison de type TIC.

Dans cet exemple, les informations relatives à l'état de l'alimentation de la passerelle 104 et les informations fournies par la liaison 103 de type TIC sont exploitées par la machine d'état 300.

Comme illustré précédemment, le signal Spwr indique la présence (niveau de tension logique haut) ou l'absence (niveau de tension logique bas) d'une alimentation en sortie du bloc secteur 106. Par ailleurs, une information de statut du capteur 102, donnée par un signal dit signal TIC, témoignant soit de la présence d'un signal du compteur, soit de l'absence d'un signal du compteur, sur la liaison 103, est communiquée au microcontrôleur 112. Le signal de compteur présent, le cas échéant, sur la liaison 103, peut par ailleurs être décodé pour fournir des informations sur la consommation du compteur.

Dans la machine d'état 300, un premier état S0 réside dans le démarrage de la carte du microcontrôleur 112 ; après une telle initialisation un état S1 est atteint, qui est un état d'attente. Deux événements sont susceptibles de faire quitter l'état d'attente S1: l'absence de signal TIC, et l'absence de tension du bloc secteur.

Dans le cas de l'absence du signal TIC, on se trouve dans un état S2. Le microcontrôleur 112 détermine alors, dans une étape de décision 301, si la passerelle 104 est alimentée par la batterie 107 ; une telle détermination est réalisée en interprétant le signal Spwr reçu par le microcontrôleur 112.

Si la passerelle 104 est toujours alimentée par le bloc secteur 106, alors on conclut, dans un état S4, à une défaillance du compteur et/ou du capteur.

Si la passerelle 104 n'est plus alimentée par le bloc secteur 106, cela signifie que l'endroit à surveiller, ici un foyer domestique, n'est plus alimenté et on conclut, dans un état S5, à une défaillance du fournisseur d'électricité.

Dans le cas de l'absence d'alimentation électrique de la passerelle 104 par le bloc secteur 106, on se trouve dans un état S3. Le microcontrôleur teste alors, dans une étape de décision 302, le statut du capteur 102.

Si l'absence de signal TIC est constatée, cela signifie que le foyer domestique n'est plus alimenté. L'état S5, correspondant à une défaillance du fournisseur d'électricité, est alors observé.

Si le signal TIC est présent, le microcontrôleur 112 peut alors, dans une étape de décision 303, déterminer, en décodant le signal de compteur, si la consommation observée est nulle ou non.

Si cette consommation est non-nulle, cela signifie qu'il y a une défaillance de l'alimentation électrique de la passerelle 104. Un état S6, correspondant à l'observation d'un bloc-secteur retiré ou défaillant, est alors observé.

Si cette consommation est nulle ou quasi-nulle, cela signifie que le compteur électrique 101 a son disjoncteur positionné dans une position bloquée, ou OFF, suite à une intervention manuelle ou non. Un état S7, correspondant à l'observation d'un tel positionnement du disjoncteur, est alors observé.

A la figure 4, on illustre, au moyen d'une machine d'état 400 implémentée dans le microcontrôleur 112, un deuxième exemple, qui n'est pas couvert par les revendications. Dans cet exemple, la liaison 103 reliant le compteur 101 et le capteur 102 n'est pas une liaison de type TIC. On ne dispose donc pas du signal TIC comme dans l'exemple précédent.

Dans cet exemple, les états S0 et S1 sont identiques à ceux de l'exemple précédent. Dans le cas de l'absence d'alimentation électrique de la passerelle 104 par le bloc secteur 106, on se trouve dans l'état S3 défini dans le premier exemple. Le microcontrôleur 112 détermine alors, dans une étape de décision 401, en décodant le signal de compteur, si la consommation observée est nulle ou non.

Si cette consommation est non-nulle, cela signifie qu'il y a une défaillance de l'alimentation électrique de la passerelle 104. L'état S6, correspondant à l'observation d'un bloc-secteur retiré ou défaillant, est alors observé.

Si cette consommation est nulle ou quasi-nulle, cela signifie que le compteur électrique 101 a son disjoncteur positionné dans une position bloquée, ou OFF (c'est-à-dire que l'alimentation électrique est coupée), suite à une intervention manuelle ou non ou qu'il y a une défaillance du fournisseur d'électricité. Un état S8 est alors observé, correspondant à l'observation d'un tel positionnement du disjoncteur ou à la défaillance du fournisseur d'électricité, la distinction entre ces deux états ne pouvant dans cet exemple être effectuée.

Dans les deux exemples décrits, à l'issue des états S4, S5, S6, S7 ou S8, le procédé est repris à l'état S1.

## Revendications

1. Procédé de détermination de l'origine de pannes de courant dans un lieu équipé d'un compteur (101), ledit compteur (101) étant associé à un capteur (102) apte à échanger des informations avec une passerelle (104), ladite passerelle (104) étant alimentée électriquement par un bloc secteur (106) ou, en cas de défaillance du bloc secteur (106), par une batterie (107), ledit procédé comporte:
▪ une étape d'observation d'une phase d'attente d'événement (S1) ;
▪ une étape de détection au moyen d'un microcontrôleur (112) présent dans la passerelle (104) une défaillance de l'alimentation du bloc secteur (106) ;
▪ en cas de détection d'une défaillance de l'alimentation du bloc secteur (106), déterminer, en décodant au moyen du microcontrôleur (112) le signal de compteur présent sur la liaison (103) reliant le capteur (102) au compteur (101), si une consommation d'énergie du compteur (101) est nulle ou non, ledit signal de compteur est du type Téléinformation Client TIC;
- si le signal de compteur décodé révèle une consommation d'énergie nulle, interpréter (S8) le signal de compteur comme révélateur d'une défaillance d'un fournisseur d'électricité du lieu équipé du compteur ou comme révélateur de la présence d'un disjoncteur du lieu considéré dans une position bloquée ;
- si le signal de compteur décodé révèle une consommation d'énergie non nulle, interpréter (S6) le signal de compteur comme révélateur d'une défaillance du bloc secteur (106),
▪ une étape de détection, au moyen d'un microcontrôleur (112), d'une absence du signal de type TIC présent sur la liaison (103) reliant le capteur (102) au compteur (101) ;
▪ en cas d'absence du signal de type TIC présent sur la liaison (103) reliant le capteur (102) au compteur (101) et si l'absence du signal de type TIC est détectée avant la défaillance de l'alimentation du bloc secteur, déterminer (301) si la passerelle (104) est alimentée par la batterie (107) ;
- si la passerelle (104) est alimentée par la batterie (107), interpréter (S5) l'absence de signal de type TIC comme révélatrice d'une défaillance du fournisseur d'électricité ;
- si la passerelle (104) n'est pas alimentée par la batterie (107), interpréter (S4) l'absence de signal de type TIC comme révélatrice d'une défaillance du compteur (101) et/ou du capteur (102).

2. Procédé selon la revendication 1 **caractérisé en ce qu'**il comporte, en cas de détection d'une défaillance de l'alimentation du bloc secteur (106), les différentes étapes supplémentaires consistant à :
▪ déterminer (302) si le signal de type signal TIC est effectivement échangé entre le compteur (101) et le capteur (102), interpréter (S5) l'absence de signal TIC comme révélatrice d'une défaillance du fournisseur d'électricité ; dans l'affirmative, déterminer (303), en décodant au moyen du microcontrôleur (112) le signal de compteur présent sur une liaison (103) reliant le capteur (102) au compteur (101), si une consommation d'énergie du compteur (101) est nulle ou non ;
▪ si le signal de compteur décodé révèle une consommation d'énergie nulle, interpréter (S7) le signal de compteur comme révélateur de la présence du disjoncteur du lieu considéré dans une position bloquée ; si le signal de compteur décodé révèle une consommation d'énergie non nulle, interpréter (S6) le signal de compteur comme révélateur d'une défaillance du bloc secteur (106).

3. Dispositif comprenant des moyens pour la mise en oeuvre du procédé selon l'une quelconque des **revendications 1 à** 2, lesdits moyens comprenand ledit microcontrôleur (112).

## Patentansprüche

1. Verfahren zum Bestimmen der Ursache von Stromausfällen an einem Ort, der mit einem Zähler (101) ausgestattet ist, wobei der Zähler (101) einem Sensor (102) zugeordnet ist, der imstande ist, Informationen mit einem Gateway (104) auszutauschen, wobei das Gateway (104) von einem Netzteil (106) oder, bei Versagen des Netzteils (106), von einer Batterie (107) elektrisch versorgt wird, wobei das Verfahren aufweist:
▪ einen Beobachtungsschritt einer Ereigniserwartungsphase (S1);
▪ einen Detektionsschritt, mittels des in dem Gateway (104) vorhandenen Mikrocontrollers (112), eines Versagens der Versorgung des Netzteils (106) ;
▪ bei Detektion eines Versagens der Versorgung des Netzteils (106), Bestimmen, durch Dekodieren mittels des Mikrocontrollers (112), des auf der Verbindung (103), die den Sensor (102) mit dem Zähler (101) verbindet, vorhandenen Zählersignals, wenn ein Energieverbrauch des Zählers (101) Null ist oder nicht, wobei das Zählersignal vom Typ Ferninformation Kunde TIC ist;
- wenn das dekodierte Zählersignal einen Energieverbrauch Null aufdeckt, Auslegen (S8) des Zählersignals als Aufdeckung eines Versagens eines Energielieferanten des Ortes, der mit dem Zähler ausgestattet ist, oder als Aufdeckung des Vorhandenseins eines Schutzschalters des entsprechenden Ortes in einer blockierten Position;
- wenn das dekodierte Zählersignal einen Energieverbrauch nicht Null aufdeckt, Auslegen (S6) des Zählersignals als Aufdeckung eines Versagens des Netzteils (106),
▪ einen Detektionsschritt, mittels eines Mikrocontrollers (112), einer Abwesenheit des auf der Verbindung (103), welche den Sensor (102) mit dem Zähler (101) verbindet, vorhandenen Signals vom Typ TIC;
▪ bei Abwesenheit des auf der Verbindung (103), welche den Sensor (102) mit dem Zähler (101) verbindet, vorhandenen Signals vom Typ TIC und wenn die Abwesenheit des Signals vom Typ TIC vor dem Versagen der Versorgung des Netzteils (106) festgestellt wird, Bestimmen (301), ob das Gateway (104) von der Batterie (107) versorgt wird,
- wenn das Gateway (104) von der Batterie (107) versorgt wird, Auslegen (S5) der Abwesenheit eines Signals vom Typ TIC als ein Versagen des Stromlieferanten aufdeckend;
- wenn das Gateway (104) nicht von der Batterie (107) versorgt wird, Auslegen (S4) der Abwesenheit eines Signals vom Typ TIC als ein Versagen des Zählers (102) und/oder des Sensors (102) aufdeckend.

2. Verfahren nach Anspruch 1, **dadurch gekennzeichnet, dass** es bei Detektion eines Versagens der Versorgung des Netzteils (106) die verschiedenen zusätzlichen Schritte aufweist, die darin bestehen:
▪ Bestimmen (302), ob das Signal vom Typ TIC wirklich zwischen dem Zähler (101) und dem Sensor (102) ausgetauscht wird, Auslegen (S5) der Abwesenheit eines TIC-Signals als ein Versagen des Stromlieferanten aufdeckend; wenn ja, Bestimmen (303), durch Dekodieren mittels des Mikrocontrollers (112) des auf einer Verbindung (103), welche den Sensor (102) mit dem Zähler (101) verbindet, vorhandenen Zählersignals, ob ein Energieverbrauch des Zählers (101) Null ist oder nicht;
▪ wenn das dekodierte Zählersignal einen Energieverbrauch Null aufdeckt, Auslegen (S7) des Zählersignals als die Anwesenheit des Schutzschalters des entsprechenden Ortes in einer blockierten Position aufdeckend; wenn das dekodierte Zählersignal einen Energieverbrauch nicht Null aufdeckt, Auslegen (S6) des Zählersignals als ein Versagen des Netzteils (106) aufdeckend.

3. Vorrichtung, umfassend Mittel für die Durchführung des Verfahrens nach einem der Ansprüche 1 bis 2, wobei die Mittel den Mikrocontroller (112) umfassen.

## Claims

1. A method for determining the cause of power outages in a place equipped with a meter (101), said meter (101) being associated with a sensor (102) able to exchange information with a gateway (104), said gateway (104) being electrically powered by a power pack (106) or, in case of failure of the power pack (106), by a battery (107), said method includes:
▪ a step of observing an event waiting phase (S1);
▪ a step of detecting by means of a microcontroller (112) present in the gateway (104) a power failure of the power pack (106);
▪ in case of detecting a power failure of the power pack (106), determining, by decoding by means of the microcontroller (112) the meter signal present on the link (103) connecting the sensor (102) to the meter (101), if an energy consumption of the meter (101) is null or not, said meter signal is of the Client Teleinformation TIC type;
- if the decoded meter signal reveals a null energy consumption, interpreting (S8) the meter signal as revealing a failure of an electrical power supplier for the place equipped with the meter or as revealing the presence of a circuit breaker for the place considered in a blocked position;
- if the decoded meter signal reveals a non null energy consumption, interpreting (S6) the meter signal as revealing a failure of the power pack (106),
▪ a step of detecting, by means of a microcontroller (112), an absence of the TIC type signal present on the link (103) connecting the sensor (102) to the meter (101);
▪ in case of an absence of the TIC type signal present on the link (103) connecting the sensor (102) to the meter (101) and if the absence of the TIC type signal is detected before the power failure of the power pack, determining (301) whether the gateway (104) is powered by the battery (107);
- if the gateway (104) is powered by the battery (107), interpreting (S5) the absence of TIC type signal as revealing a failure of the electrical power supplier;
- if the gateway (104) is not powered by the battery (107),
interpreting (S4) the absence of TIC type signal as revealing a failure of the meter (101) and/or the sensor (102).

2. The method according to claim 1, **characterised in that** it includes, in case of detecting a power failure of the power pack (106), the different further steps of:
▪ determining (302) whether the TIC type signal is actually exchanged between the meter (101) and the sensor (102), interpreting (S5) the absence of TIC signal as revealing a failure of the electrical power supplier; if yes, determining (303), by decoding by means of the microcontroller (112) the meter signal present on a link (103) connecting the sensor (102) to the meter (101), if an energy consumption of the meter (101) is null or not;
▪ if the decoded meter signal reveals a null energy consumption, interpreting (S7) the meter signal as revealing the presence of the circuit breaker of the place considered in a blocked position; if the decoded meter signal reveals a non null energy consumption, interpreting (S6) the meter signal as revealing a failure of the power pack (106).

3. A device comprising means for implementing the method according to any of claims 1 and 2, said means comprising said microcontroller (112).
